# EUROPÄISCHE PATENTSCHRIFT

(11) **EP 1 668 356 B1**
(45) Veröffentlichungstag und Bekanntmachung des Hinweises auf die Patenterteilung: **17.06.2009**
(21) Anmeldenummer: 04765420.7
(22) Anmeldetag: 20.09.2004
(51) Int. Cl.: G01N 33/483, C30B 31/04, C30B 29/58

(54) **VERFAHREN ZUR STEUERUNG DER BEHANDLUNG EINES KRISTALLS MIT EINER FLÜSSIGKEIT**
METHOD FOR CONTROLLING THE TREATMENT OF A CRYSTAL BY MEANS OF A LIQUID
PROCEDE POUR COMMANDER LE TRAITEMENT D'UN CRISTAL AU MOYEN D'UN LIQUIDE

(30) Priorität: 19.09.2003 DE 10343522
(43) Veröffentlichungstag der Anmeldung: 14.06.2006
(73) Patentinhaber: Proteros Biostructures GmbH, 82152 Martinsried (DE)
(72) Erfinder: NEUEFEIND, Torsten, 82131 Gauting (DE); BRANDSTETTER, Hans, 82131 Gauting (DE)
(74) Vertreter: Huenges, Martin
(86) Internationale Anmeldenummer: PCT/EP2004/010539
(87) Internationale Veröffentlichungsnummer: WO 2005/031344

(56) Entgegenhaltungen:
- WO-A1-02/057520
- WO-A2-99/45379
- WO-A2-03/050598
- DE-C1- 19 842 797
- GB-A- 2 249 492
- SANTESSON S ET AL: "Screening of nucleation conditions using levitated drops for protein crystallization" ANALYTICAL CHEMISTRY, Bd. 75, Nr. 7, 1. April 2003 (2003-04-01), Seiten 1733-1740, XP001170672 ISSN: 0003-2700

## Beschreibung

In der Proteinkristallographie kommt es häufig vor, daß vor der kristallographischen Messung Liganden oder Inhibitoren in eine Ptoteinstruktur bzw. einen Proteinkristall eingebracht werden sollen. Ziel ist es dabei, die kristallographische Struktur eines Proteins ohne und mit Ligand oder Inhibitor zu vergleichen und die räumliche Anordnung des Liganden oder Proteins zu ermitteln. Liganden können hierbei alle an ein Protein oder Polypeptid bindenden Moleküle oder Substanzen sein, die bspw. inhibitorische Wirkung oder auch agonistische Wirkung auf die Funktion des Proteins haben können. Ggf. können Liganden organisch-chemische Moleküle sein oder auch (modifizierte) Antikörper oder Antikörperfragmente, native Bindungspartner oder Fragmente, ggf. modifiziert, vom kristallisierten Protein. Weiterhin werden regelmäßig auch Schwermetallatom-Derivate in der Kristallographie benötigt, um die entsprechende Phaseninformationen zu erhalten. Ein Ligand i.S. der vorliegenden Erfindung kann daher auch ein an das kristallisierte Protein bindendes Schwermetallatom(salz) sein.

Ein im Stand der Technik bekanntes Verfahren zum Einbringen von Liganden, bspw. Inhibitoren, ist das sogenannte "Soaking" mit einem Puffer, der aus der Kristallisationslösung sowie dem Liganden besteht. Falls ein in den Kristall zu "soakender" Ligand schlecht oder nur schwerlöslich ist, können dem Puffer zur Erhöhung der Löslichkeit desselben weitere Substanzen als Löslichkeitsverbesserer zugesetzt werden. Beispielsweise kann es sich um Lösungsmittel wie DMSO (Dimethylsulfoxid), TFE, Ethanol, 2-Nitropropan oder andere organische Lösungsmittel handeln.

Das "Soaking"-Verfahren besitzt verschiedene Nachteile. So besteht ein Nachteil darin, daß die Kristalle beim "Soaking" einer anderen Umgebung ausgesetzt werden müssen, wodurch der Kristall Schaden erleiden kann, d.h. insbesondere, dass die Mikrostruktur des Kristalls nach dem "Soaking" Unregelmäßigkeiten aufweist, die das Diffraktionsvermögen des Kristalls beeinträchtigen. Sollen z.B. schwerlösliche Inhibitoren oder Liganden in die Proteinkristallstruktur eingebracht werden, so benötigt man sehr hohe Konzentrationen an LösungsmitteL Gerade hohe Lösungsmittelkonzentrationen führen aber häufig zur Zerstörung der fragilen Proteinkristalle, wie zuvor erwähnt

Darüber hinaus besteht ein weiterer Nachteil des herkömmlichen "Soaking"-Verfahrens in dem hohen Zeitaufwand des Verfahrens. Dieser ist zum einen durch die unter Umständen zahlreichen (repetitiven) "Soaking"-Prozesse bedingt, die ggf. unter Veränderung der Konzentrationsverhältnisse des zu "soakenden" Liganden durchlaufen werden müssen, um überhaupt eine geeignete, die Liganden oder Inhibitoren enthaltende, also komplexierte Proteinkristallstruktur (Cokristall) zu erhalten, und zum anderen dadurch, daß bereits ein einzelner Soaking-Prozeß bereits sehr zeitaufwendig sein kann, da bspw. die Diffnsionskinetik beachtet werden muß.

Ein weiterer Nachteil des "Soaking"-Verfahrens besteht darin, daß röntgenkristallographische Untersuchungen oder Untersuchungen des Proteinkristalls mit Röntgenstrahlung während des "Soaking'-Verfahrens technisch nicht möglich sind.

Daher sind eine verbesserte Vorrichtung und ein verbessertes Verfahren zur Behandlung von Kristallen entwickelt worden, die in der vom gleichen Anmelder wie die vorliegende Anmeldung stammenden Deutschen Patentanmeldung Nr. 103 36 110.3 beschrieben worden sind. Diese Anmeldung wird daher insoweit vollumfänglich in die Offenbarung der vorliegenden Anmeldung einbezogen.Weitere Vorrichtungen bzw. Verfahren zur Behandlung von Kristallen sind aus der Druckschriften ANALYTICAL CHEMISTRY, Bd. 75, Nr. 7, 1. April 2003, Seiten 1733-1740, XP001170672, ISSN 0003-2700 und WO 02/057520 A1 bekannt.

Die verbesserte Vorrichtung und das verbesserte Verfahren weisen eine Halterung zur Befestigung des Kristalls und ein Mikrodosiersystem auf, das im Verhältnis zur Halterung so angeordnet ist, daß damit Mikro-Tropfen einer Flüssigkeit, die bspw. Lösungsmittel und mindestens einen Ligandentyp aufweist, auf den in der Halterung befestigten Kristall aufgebracht werden können. Durch das Auftropfen von Mikro-Tropfen mit der erfindungsgemäßen Vorrichtung läßt sich eine wesentlich schonendere Behandlung von Kristallen und insbesondere Proteinktistallen mit bestimmten aufzubringenden Substanzen, die in einer Lösung enthalten sind, erreichen. Diese Substanzen können bei Proteinkristallen Liganden, bspw. Inhibitoren, Substrate oder Reaktanden, sein. Bei den Liganden wird es sich bei Proteinkristallen typischerweise um Agonisten, Substrate, Antagonisten oder Cofaktoren der kristallisierten Proteine handeln. Gemäß einer Abwandlung der verbesserten Vorrichtung ist die Kristallhalterung so ausgebildet, daß durch die Halterung ein Gasstrom geführt werden kann, der auf den in der Halterung befestigten Kristall gerichtet ist Dadurch kann der Kristall während der Behandlung durch die Mikro-Tropfen in einer definierten Umgebung gehalten werden.

Es hat sich gezeigt, daß die Steuerung des Tropfenbehandlungsprozesses schwierig ist, denn die Tropfenbehandlung muß in sehr präziser Weise durchgeführt werden, damit insbesondere empfindliche Proteinkristalle während des Kristallbehandlungsprozesses nicht beschädigt werden.

Die Aufgabe der vorliegenden Erfindung liegt daher darin, ein verbessertes Verfahren zur Steuerung der Behandlung eines Kristalls mit einer Flüssigkeit zu schaffen.

Diese Aufgabe wird durch ein Verfahren zur Steuerung der Behandlung eines Kristalls mit einer Flüssigkeit gemäß Anspruch 1 gelöst.

Gemäß dieser Lösung wird eine einfache Steuerung des Kristallbehandlungsprozesses dadurch erreicht, daß permanent die Fläche des Kristalls mit Flüssigkeitsumgebung in einem zweidimensionalen Bild oder das Volumen des Kristalls überwacht wird und in Abhängigkeit von Änderungen der Fläche oder des Volumens z.B. die Frequenz mit der die Tropfen auf den Kristall mit Flüssigkeitsumgebung aufgebracht werden, so korrigiert wird, daß eine schonende Behandlung des Kristalls möglich ist

Vorteilhafte Weiterbildungen der Erfindung sind in den Unteransprüchen angegeben.

Bevorzugte Ausführungsformen der vorliegenden Erfindung werden nachfolgend unter Bezug auf die beiliegende Zeichnung näher erläutert. Es zeigen
Fig. 1 eine teilweise im Schnitt dargestellte Ansicht einer bei einer Ausführungsform des erfindungsgemäßen Verfahrens verwendeten Vorrichtung zum Behandeln eines Kristalls mit einer Lösung,
Fig. 2 ein Gehäuse eines bei einer Ausführungsform des erfindungsgemäßen Verfahren verwendeten Steuergeräts zur Steuerung eines bei einer Ausführungsform des erfindungsgemäßen Verfahrens verwendeten Mikrodosiersystems,
Fig. 3 ein Blockschaltbild zur Veranschaulichung der Steuerung der Behandlung eines Kristalls mit einer Flüssigkeit gemäß einer Ausführungsform eines erfindungsgemäßen Verfahrens;
Fig. 4a) die gemäß dem erfindungsgemäßen Verfahren ermittelte Änderung der Fläche des Kristalls mit Flüssigkeitsumgebung in einem aufgenommenen zweidimensionalen Bild und aufgetragen über die Zeit;
Fig. 4b) die Änderung der Ausdehnung des Kristalls mit Flüssigkeitsumgebung in x- und y-Richtung in einem aufgenommenen zweidimensionalen Bild und aufgetragen über die Zeit;
Fig. 5 ein Flüssigkeitszufuhrsystem für ein Mikrodosiersystem, das bei einer Ausführungsform des erfindungsgemäßen Verfahrens verwendet werden kann.
Fig. 6 zwei Graphen mit abnehmender Luftfeuchtigkeit und zunehmender Tropfenfrequenz.

Die Erfindung wird im folgenden am Beispiel der Steuerung der Behandlung von Proteinkristallen beschrieben, sie kann aber auch in analoger Weise bei der Steuerung der Flüssigkeitsbehandlung von anderen Kristallen eingesetzt werden.

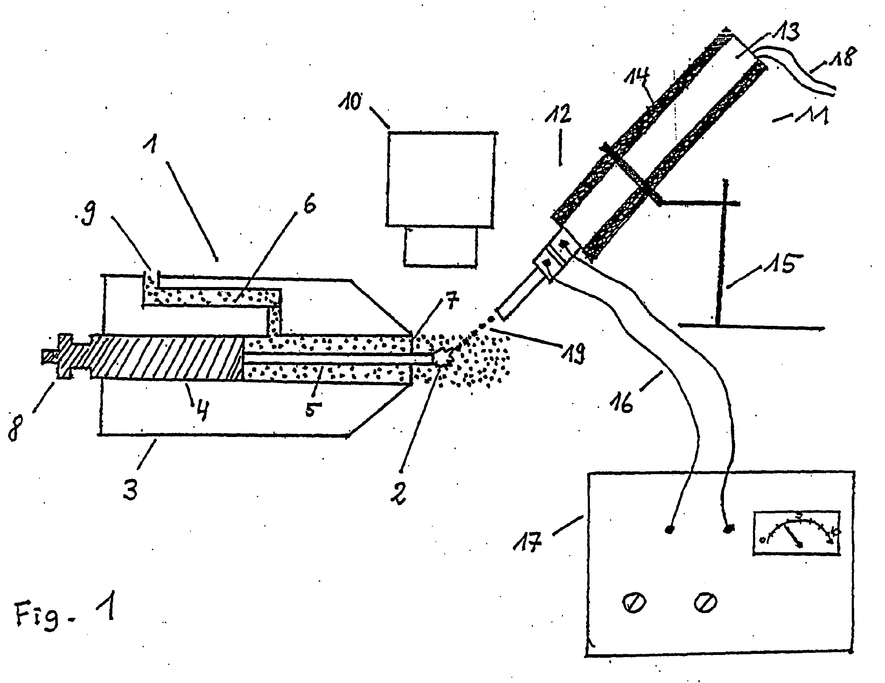

Zur Veranschaulichung einer Anwendung des erfindungsgemäßen Verfahrens wird zunächst eine bei einer Ausführungsform des Verfahrens verwendete Vorrichtung zur Behandlung eines Kristalls mit einer Flüssigkeit beschrieben, die in der Fig. 1 dargestellt ist Dabei ist links in der Fig. 1 eine Halterung 1 dargestellt, die dazu dient, einen Proteinkristall 2 zu befestigen. Die in der Fig. 1 dargestellte Halterung, die in ihrer generischen Art auch als "free mounting system" bezeichnet wird, ist bereits aus dem Stand der Technik bekannt und z.B. in der Deutschen Patentschrift DE 198 42 797 C1 sowie in der Anmeldung WO 03/050 598 A2 beschrieben worden.

Die Halterung 1, die in der Fig. 1 in einer Schnittansicht von der Seite dargestellt ist, besteht im wesentlichen aus einem Trägerblock 3, der ein einschiebbares Einsatzteil 4 aufweist, das in eine Öffnung des Trägerblocks 3 eingeschoben werden kann. Am Einsatzteil ist eine Haltekapillare 5 angebracht, an deren freiem Auflageende der Proteinkristall 2 gehalten wird. Die Haltekapillare besteht z.B. aus einer Mikropipette, in der über eine in der Fig. 1 nicht dargestellte und mit dem anderen Ende der Mikropipette verbundene Pumpvorrichtung ein Unterdruck erzeugt wird, der dazu dient, den Proteinkristall 2 an dem freien Auflageende zu halten. Das linke Ende 8 des Einsatzteils ist so ausgebildet, daß daran die Halterung 1 an einem Goniometerkopf einer Röntgen- oder Synchrotronbestrahlungsanlage befestigt werden kann.

Anstelle der Mikropipette kann zum Halten des Kristalls auch ein sogenannter "Loop", d.h. eine feine Schlaufe, die z.B. aus Nylon bestehen kann, verwendet werden. Ein solcher "Loop" wird z.B. von der Firma Hampton Research angeboten.

In einer Röntgen- oder Synchrotronbestrahlungsanlage kann die Beugung von Röntgenstrahlen beim Durchgang durch das Kristallgitter des Proteinkristalls ausgenutzt werden, um aus dem Beugungsbild auf die räumliche Anordnung der Atome und Moleküle in dem kristallisierten Protein zu schließen bzw. die Struktur durch mathematische Operationen zu errechnen. Die erforderlichen Röntgenstrahlen können z.B. durch Beschuß von Kupfer oder anderen Materialien mit Elektronen erzeugt werden (bspw. CuKa-Strahlung). Alternativ kann die Röntgenstrahlung auch in einem Synchrotron, d.h. einem Teilchenbeschleuniger, erzeugt werden, bei dem die Röntgenstrahlung von auf Kreisbahnen beschleunigten Elektronen emittiert wird. Das Synchrotron besitzt trotz des größeren apparativen Aufwands eine Reihe von Vorteilen gegenüber der herkömmlichen Erzeugung von Röntgenstrahlung durch Elektronenbeschuß von Metallen. So besitzen die durch Synchrotrone erzeugten Röntgenstrahlen eine höhere Intensität und können in verschiedenen Wellenlängen gewählt werden. Auch besteht auf diese Weise die Möglichkeit, "weißes" Röntgenlicht einzusetzen und damit den Kristall mit Röntgenblitzen, die Röntgenstrahlen aller Wellenlängen aufweisen, zu beschießen. Darüber hinaus lassen sich die Messungen mit dem Synchrotron wesentlich schneller als mit herkömmlichen Röntgenbestrahlungsanlagen durchführen.

In die Halterung 1 ist ferner ein Gaskanal 6 integriert, dessen Mündungsende 7 auf das freie Auflageende der Haltekapillare 5 gerichtet ist, an dem der Proteinkristall 2 befestigt ist. Dabei wird der am Auflageende angebrachte Proteinkristall 2 vollständig vom Gasstrom aus dem Gaskanal 6 umschlossen, so daß eine definierte Gasatmosphäre um den Proteinkristall herum erzeugt werden kann. Der Gaskanal 6 ist an seinem in der Fig. 1 als offen dargestellten Ende mit einem Gaserzeugungsnnittel und einem Gasmischmittel verbunden, mit dem die Zusammensetzung des Gasstroms variabel eingestellt werden kann. Falls das um den Proteinkristall herum befindliche Gas Luft ist, kann das Gasmischmittel z.B. dazu dienen, die Luftfeuchtigkeit auf einen vorherbestimmten optimalen Wert einzuregeln. Es kann Darüber hinaus auch ein Temperatureinstellmittel vorgesehen sein, mit dem die Temperatur des Gasstroms gemessen und auf einen bestimmten vorgebbaren Wert eingeregelt werden kann. Auch können andere gasförmige Substanzen dem Gasstrom beigemischt werden, so dass bspw. der Stickstoff- oder Sauerstoffgehalt der Luft modifiziert, bspw. erhöht, werden kann.

In der Deutschen Patentanmeldung Nr. 10232172.8-52 mit dem Titel "Vorrichtung und Verfahren zur Erzeugung einer definierten Umgebung für partikelförmige Proben" ist bereits eine Vorrichtung und ein Verfahren beschrieben, mit dem sich eine hochgenaue und langzeitstabile Feuchteeinstellung eines durch die oben beschriebene Halterung geführten feuchten Gasstroms am Ort des partikelförmigen Kristalls erreichen läßt.

Über dem Kristall ist ein Mikroskop mit Videosystem 10 angebracht, mit dem der Proteinkristall während der Behandlung mit der Substanz beobachtet werden kann. Ggf. kann infolge der Beobachtung über das Videosystem der Behandlungsmodus modifiziert oder auch die Behandlung eingestellt werden.

Die in der Fig. 1 dargestellte erfindungsgemäße Vorrichtung zum Behandeln eines Kristalls mit einer Substanz umfaßt darüber hinaus ein Mikrodosiersystem 11, das rechts in der Fig. 1 in einer Seitenansicht im Schnitt dargestellt ist.

Das Mikrodosiersystem 11 umfaßt eine sogenannte Piezopipette 12, die in einem Stativ 15 gehalten wird und so auf den Proteinkristall 2 ausgerichtet ist, daß dieser mittels der Piezopipette mit Tropfen beschossen werden kann. Die Piezopipette ist in der Fig. 1 aus Gründen der Anschaulichkeit in einem vergrößerten Maßstab im Verhältnis zur Halterung 1 dargestellt. Die Piezopipette ist so angeordnet, daß die Spitze der Piezopipette einen Abstand von typischerweise 3 mm zu dem Proteinkristall aufweist. Vorzugsweise liegt dieser Abstand in einem Bereich von 1 - 5 mm, kann jedoch unter besonderen Umständen auch größer oder kleiner gewählt werden.

Die Piezopipette 12 besteht aus einer Glaskapillare 13, die z.B. aus Borosilicatglas bestehen kann. Der Durchmesser der Öffnung der Glaskapillare ist einer der Faktoren, die die Größe der von der Piezopipette abgegebenen Mikro-Tropfen beeinflussen und kann z.B. in einem Bereich zwischen 5 und 50 Mikrometer liegen. Die Glaskapillare 13 ist von einem piezoelektrischen Element 14 umschlossen, das aus einem Material besteht, das einen piezoelektrischen Effekt zeigt. Es kann sich bei diesem Material z.B. um einen Piezokristall handeln. Das piezoelektrische Element 14 ist darüber hinaus über zwei Kabel 16 mit einem Steuergerät 17 elektrisch verbunden, mit dem eine Spannung an das piezoelektrische Element 14 angelegt werden kann. Wird ein Spannungspuls durch das Steuergerät 17 an das piezoelektrische Element 14 angelegt, so wird das piezoelektrische Element 14 und mit diesem auch die Glaskapillare 13 kontrahiert und ein Tropfen aus der Öffnung der Piezopipette herausgeschossen. Über das Steuergerät 17 können unterschiedlich geformte Spannungspulse an die Piezopipette angelegt werden, deren Formen die Form und Größe der Mikro-Tropfen und deren Frequenz die Frequenz der Mikro-Tropfen beeinflussen.

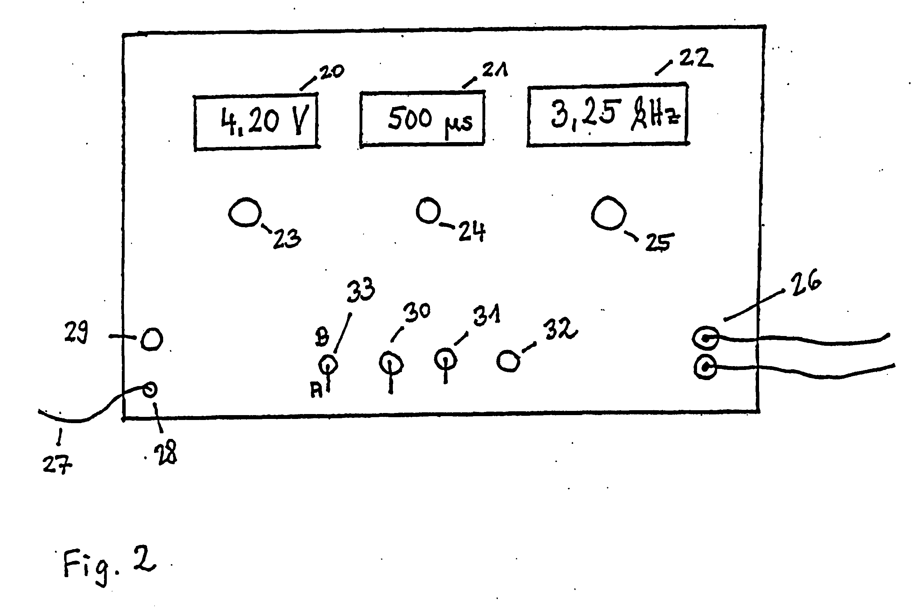

In der Fig. 2 ist ein Gehäuse eines möglichen Steuergeräts zur Steuerung der Piezopipette dargestellt, wobei die einzelnen Steuerungsmöglichkeiten anhand der in der Fig. 2 dargestellten Schalter und Steuerelemente des Steuergeräts erläutert werden sollen. Das Steuergerät weist zunächst drei verschiedene LCD-Anzeigen 20, 21 und 22 auf. Auf der ersten LCD-Anzeige 20 wird der aktuelle Wert für den Spannungspegel der Impulsausgangsspannung für das Piezopipettensteuersignal angezeigt Dieser Wert läßt sich über einen Drehregler 23 variabel einstellen. Auch die Impulsweite des Pipettenansteuersignals, die auf der zweiten LCD-Anzeige 21 in Mikrosekunden angezeigt wird, läßt sich mittels eines zweiten Drehreglers 24 einstellen. Schließlich ist ein Druckschalter 25 vorgesehen, um die Frequenz der an die Piezopipette angelegten Spannungsimpulse einzustellen, die auf der dritten LCD-Anzeige 22 angezeigt wird. Diese Frequenz, die bis zu einige kHz betragen kann (z.B. 2 kHz) entspricht der Frequenz, mit der die Mikro-Tropfen aus der Piezopipette auf den Kristall geschleudert werden. Der Einstellbereich der Frequenz kann z.B. in einem Bereich zwischen 1 Hz und 6 kHz liegen. Die Höhe der Impulsausgangsspannung und die Weite der Spannungsimpulse müssen so eingestellt werden, daß es überhaupt zu einer Tropfeneneugung mit der Piezopipette kommt.

Das Steuergerät weist ferner zwei Eingänge 26 auf, an denen die beiden Verbindungskabel der Piezopipette angeschlossen werden. Ferner sind ein Netzkabel 27 sowie ein Netzanschluß 28 zur Stromversorgung des Steuergeräts vorgesehen. Über den weiteren Signaleingang 29 können von anderen elektrischen Geräten vorgegebene Spannungsimpulsfolgen angelegt werden, um die Mikro-Tropfenerzeugung auszulösen und die Mikro-Tropfenfolge und -form von außen zu steuern, was unten näher beschrieben wird.

Der Schalter 30 ist dazu vorgesehen, den Piezopipettenbetrieb ein- und auszuschalten. Über den weiteren Schalter 31 kann zwischen Einzelspannungsimpulsbetrieb und kontinuierlichem Spannungsimpulsbetrieb umgeschaltet werden, d.h. zwischen Einzeltropfenerzeugung und kontinuierlicher Tropfenerzeugung. Für die Einzeltropfenerzeugung kann ferner ein Taster 32 vorgesehen sein, über den einzelne Spannungsimpulse an die Piezopipette angelegt werden können, wenn es gewünscht ist, einzelne Tropfen per Handbetrieb auf den Kristall zu schießen.

Der Schalter 33 dient schließlich dazu zwischen verschiedenen Impulsformen der an die Piezopipette 12 angelegten Spannungsimpulse variieren zu können. In der Schalterstellung A kann z.B. ein vorgegebener Standard-Rechteckspannungsimpuls mit vorherbestimmter Dauer und Höhe erzeugt werden, während in der Schalterstellung B ein Rechteckspannungsimpuls erzeugt werden kann, dessen Dauer und Höhe variabel eingestellt werden kann. Es ist natürlich bei anderen Ausführungen auch denkbar, daß Spannungsimpulse angelegt werden, die von der Rechteckform abweichen.

Verschiedene Größen der Mikro-Tropfen, die z.B. für verschiedene Kristallgrößen geeignet sein können, können über die Variation der Spannungspulsweiten und Spannungspulshöhen eingestellt werden, die die an die Piezopipette angelegten Spannungen aufweisen.

Die Glaskapillare 13 der Piezopipette 12 ist typischerweise über eine Zuleitung 18 mit einem in der Figur 1 nicht dargestellten Vorratsgefäß verbunden, das die Lösung enthält, die auf den Proteinkristall getropft werden soll. Diese Lösung enthält die Substanz oder die Substanzen, mit der bzw. denen der Proteinkristall behandelt werden soll. Die Oberkante des Flüssigkeitsspiegels der sich im Vorratsgefäß befindenden Flüssigkeit sollte dabei etwas höher als die Unterkante der Pipettendüse eingestellt werden. Alternativ dazu kann die Flüssigkeit bei einer Lösung ohne Vorratsgefäß aber auch direkt über die Auslaßöffnung der Piezopipette in die Piezopipette gesaugt werden, um sie dann später wieder abgeben zu können. Es kann auch eine Temperiervorcichtung um das Vorratsgefäß herum angeordnet sein, um die in dem Vorratsgefäß sich befindende Flüssigkeit auf eine gewünschte Temperatur zu bringen. Gemäß einer Ausführungsform kann vor dem Aufbringen der Lösung auf den Kristall der pH-Wert und/oder die Ionenstärke (bzw. spezifische Salzkonzentrationen) der Lösung gemäß den im Stand der Technik bekannten Verfahren auf einen gewünschten Wert eingestellt werden.

Unter Mikro-Tropfen im Sinne der vorliegenden Erfindung sollen Tropfen zu verstehen sein, deren Volumen kleiner als 1 nl ist, wobei das Volumen der Mikro-Tropfen vorzugsweise zwischen 1 nl (nanoliter) und 1 pl (picoliter), noch weiter bevorzugt zwischen 100 pl und 20 pl und noch stärker bevorzugt zwischen 20 pl und 1 pl liegt. Aus diesen Größen lassen sich über die Volumensformel die entsprechenden geeigneten Durchmesser der Tropfen errechnen, wenn man näherungsweise davon ausgeht, daß die Tropfen kugelförmig sind. Das gewünschte Tropfenvolumen kann erfindungsgemäß eingestellt werden.

Die Mikro-Tropfen der auf den Kristall aufzubringenden Flüssigkeit sind dabei vorzugsweise kleiner als das Volumen des Kristalls. Ein typisches Kristallvolumen kann dabei z.B. in einer Großenördnung von 1 nl liegen.

Das Volumen der im speziellen Fall verwendeten Mikro-Tropfen wird in Abhängigkeit vom Volumen des Kristalls gewählt. Dabei betragen die Volumen der Mikrotropfen weniger als 50 %, z.B. 1 bis 20 %, des Kristallvolumens und vorzugsweise von 1 bis 10 % des Kristallvolumens.

Die Tropfenerzeugung mittels einer Piezopipette ist nur ein Beispiel für eine Mikrodosiervorrichtung. Es können auch andere Vorrichtungen verwendet werden, die in der Lage sind, Mikro-Tropfen zu erzeugen.

So kann z.B. auch ein Mikrodosiersystem verwendet werden, das eine Kapillare und ein in der Kapillare angeordnetes Mikroventil umfaßt. Dabei wird die Flüssigkeit unter Druck aus einem Vorratsgefäß auf das Mikroventil gepreßt, das von einem Steuergerät elektrisch innerhalb eines kurzen Zeitintervalls geöffnet und danach wieder geschlossen wird, um die Tropfen zu erzeugen. Die Begrenzung der Tropfengröße ergibt sich hier durch die noch steuerbare Öffnungsdauer des Ventils.

Als Mikrodosiersystem kann bei einer anderen Ausführungsform auch ein Zerstäuber dienen. Ein Zerstäuber hat allerdings gegenüber den oben beschriebenen Lösungen den Nachteil, daß das Ausrichten der Tropfen auf den Kristall schwieriger ist Daher wird vorteilhafter Weise dem Zerstäuber ein Mittel nachgeordnet, das die Orientierung der aus dem Zerstäuber erhaltenen Mikro-Tropfen auf den Kristall sicherstellt.

Bei einer Ausführungsform des erfindungsgemäßen Verfahrens wird ein Proteinkristall zunächst an dem freien Auflagenende der Haltekapillare 2 befestigt Anstelle der Haltekapillare 2 kann auch ein sogenannter "Loop", also eine Art Schlaufe, verwendet werden, in dem der Proteinkristall befestigt ist. Der Proteinkristall ist dabei frei von jeglicher Oberflächenlösung und damit zugänglich für Lösungen, die von außen direkt mittels des Miktodosiersystems aufgebracht werden können. Durch die Halterung 1 wird nun typischerweise eine Gasatmosphäre um den Proteinkristall 2 herum erzeugt, indem ein Gasstrom definierter Zusammensetzung und Temperatur durch den Gaskanal 6 der Halterung 1 geführt wird. Bei dem beschriebenen Verfahren wird es sich typischerweise um einen Luftstrom, ggf. unter Beimischung anderer gasförmiger Substanzen, mit einem geregelten Feuchtigkeitsgehalt (d.h. Wassergehalt) und einer geregelten Temperatur handeln.

In die Kristallstruktur des Proteinkristalls soll nun ein Inhibitor eingebracht werden, der Bestandteil einer Substanz ist, die der Lösung zugesetzt wurde, die sich in dem Vorratsgefäß befindet, das mit der Piezopipette verbunden ist Es hat sich durch Experimente gezeigt, daß lokal auf die Oberfläche des Kristalls aufgebrachte Lösungen (wie bspw. DMSO) mit hoher Inhibitor-Konzentration den Kristall in der Regel nicht schädigen. Nun werden durch das Steuergerät 17 elektrische Spannungspulse an die Piezopipette 12 angelegt und Mikro-Tropfen mit der Inhibitor-Lösung auf den Proteinkristall 2 geschleudert. Durch das Aufspritzen einzelner Mikro-Tropfen bleibt der den Proteinkristall umströmende Gasstrom praktisch unbeeinflußt, so daß der Proteinkristall in seiner stabilen definierten Umgebung verbleibt Die Erhaltung einer stabilen Umgebung ist insbesondere für die relativ instabilen Proteinkristalle, die durch geringe Gitterkräfte zusammengehalten werden, wichtig, damit die Kristalle nicht zerstört werden, bevor sie z.B. einer röntgenkristallographischen Untersuchung unterzogen werden. Die Feuchtigkeit des den Kristall umgebenden Luftstroms kann nun im Zusammenspiel mit der Größe und Frequenz der über die Mikrodosiervorrichtung auf den Proteinkristall aufgebrachten Tropfen so eingestellt werden, daß der Kristall möglichst sein Volumen nur wenig ändert, indem ein Gleichgewicht zwischen Abdampfen von Flüssigkeit vom Kristall und Zuwachs an Flüssigkeit durch Auftropfen von Flüssigkeit mittels der Mikrodosiervorrichtung erreicht wird. Dadurch wird der Kristall nur minimal belastet und es kann ein schonendes Einbringen des/der Liganden über die lokal aufgetragenen Mikrotropfen erreicht werden. Dieser Vorgang der Einstellung der optimalen Luftfeuchtigkeit bzw. der optimalen Auftropffrequenz durch die Mikrodosiervorrichtung kann über ein Regelelement automatisch geregelt werden, daß entsprechende Änderungen der Feuchtigkeit des Luftstroms und/oder der Auftropffrequenz vornimmt, wenn sich das gemessene Volumen des Kristalls ändert.

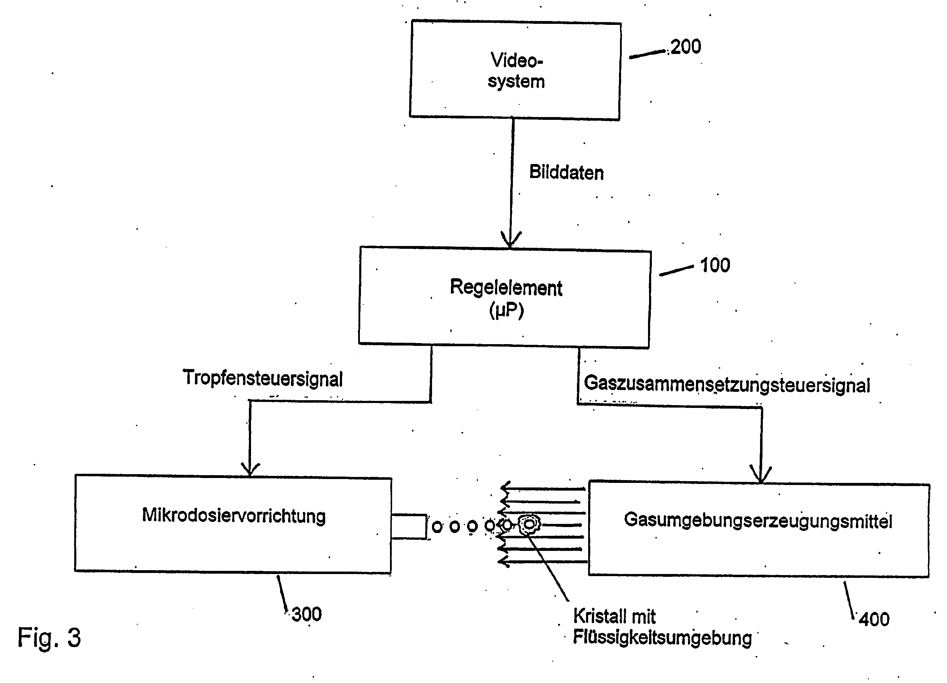

In der Fig. 3 ist ein solches Regelelement 100 in Form eines Mikroprozessors (µP) mit einem (nicht dargestellten) Speicher dargestellt, in dem Befehle gespeichert sind, die den Mikroprozessor dazu bringen können, das erfindungsgemäße Regelungsverfahren durchzuführen.

Gemäß einer Ausführungsform des erfindungsgemäßen Verfahrens wird dabei zunächst mithilfe des Videosystems ein Startbild eines Proteonkristalls mit Flüssigkeitsumgebung vor dem Beginn des Kristallbehandlungsprozesses aufgenommen. Es wird dabei der Kristall zu Beginn des Verfahrens mit einem dünnen Film von Flüssigkeit umgeben, der vorzugsweise so dünn wie möglich ist. Es wird dann ein Bildsignal, welches dieses Startbild repräsentiert, über eine Verbindung zwischen Videosystem 200 und Regelelement 100 vom Videosystem 200 zum Regelelement 100 übertragen. Dabei kann die Übertragung des Bildsignals z.B. durch ein vom Regelelement 100 zum Videosystem 200 (über eine in der Fig. 3 nicht dargestellte Verbindung) gesendetes Startbildübertragungsauslösungssignal ausgelöst werden. Alternativ kann vor dem Startbild auch ein Bild des reinen Kristalls ohne Flüssigkeitsumgebung aufgenommen werden, insbesondere, wenn das Volumen der Flüssigkeitsumgebung zu Beginn und während des Kristallbetropfungsverfahrens berechnet werden soll.

Das Bildsignal wird nun im Regelelement 100 ausgewertet und es wird die Fläche bestimmt, die der aufgenommene Proteinkristall mit Flüssigkeitsumgebung in dem zweidimensionalen aufgenommenen Bild einnimmt. Die Bestimmung kann durch eines der im Stand der Technik entwickelten Bildauswerteverfahren erfolgen, z.B. durch einfache Auszählung der Pixel, die von dem Kristall mit Flüssigkeitsumgebung in dem zweidimensionalen Bild im Vergleich zur Gesamtpixelzahl eingenommen werden. Daraufhin wird der bestimmte Wert für die Fläche des Proteinkristalls mit Flüssigkeitsumgebung als Sollwert in dem Speicher des Mikroprozessors des Regelelements abgelegt.

Nun wird vom Regelement 100 zu der Mikrodosiervorrichtung 300 (z.B. über den Eingang des Steuergeräts der Mikrodosiervorrichtung) ein Starttropfensteuersignal gesendet, das so ausgebildet ist, daß es die Anfangsfrequenz der von dem Mikrodosiersystem auf einen Kristall mit Flüssigkeitsumgebung zu Beginn der Kristallbehandlung aufzubringenden Tropfen repräsentiert. Im vorliegenden Beispiel soll diese Frequenz bei 2,5 kHz liegen. Das Starttropfensteuersignal kann aber auch so ausgebildet sein, daß es neben der Frequenz auch weitere Parameter der Tropfen repräsentiert, z.B. die Anfangsgröße und/oder Anfangform der Tropfen.

Vom Regelelement 100 wird nun erneut ein Bildübertragungsauslösungssignal zum Videosystem 200 übertragen, das darauf hin erneut die momentanen Bilddaten von dem Kristall mit Flüssigkeitsumgebung zum Regelelement 100 aussendet. Nun wird das Bildsignal im Regelelement empfangen, verarbeitet und aus dem Bildsignal werden die momentane Fläche des zweidimensionalen Bildbereichs, der die Einheit Kristall mit Flüssigkeitsumgebung repräsentiert, ermittelt. Bei der vorliegenden Ausführungsform soll der zum Anfang definierte und im Speicher des Regelelements gespeicherte Sollwert, der der Anfangsfläche entspricht, möglichst eingehalten werden, damit ein stabiles Gleichgewicht zwischen Abdampfen von Flüssigkeit und Hinzugewinn von Flüssigkeit durch Betropfen des Kristalls mit Flüssigkeitsumgebung erreicht wird, was den empfindlichen Proteinkristall am wenigsten belastet. Nun wird die erneut ermittelte Fläche mit dem vorher gespeicherten Sollwert verglichen und bei Abweichungen zwischen Fläche und Sollwert wird ein Korrekturtropfensteuersignal ermittelt und zu dem Mikrodosiersystem gesendet, wobei das Korrekturttopfensignal so ausgebildet ist, daß es eine korrigierte Frequenz (und/oder Tropfenform und/oder Tropfengröße) der von dem Mikrodosiersystem auf den Kristall mit Flüssigkeitsumgebung aufzubringenden Tropfen repräsentiert, die so gewählt ist, daß die Abweichung vom Sollwert minimiert wird. Es soll angenommen werden, daß im vorliegenden Fall eine Abweichung zwischen erneut ermitteltem Flächenwert und Startsollwert auftrat, wobei die erneut ermittelte Fläche um 5 % über der Startfläche lag. Das bedeutet, daß die Tropfenfrequenz der Mikrodosiervorrichtung zu hoch eingestellt ist, so daß der Kristall mit Flüssigkeitsumgebung ständig an Flüssigkeit zunimmt, wodurch der Proteinkristall in seiner Stabilität gefährdet ist Daher wird im vorliegenden Fall durch den Mikroprozessor des Regelements 100 ein Korrekturtropfensteuersignal ermittelt, das z.B. einer Frequenz von 1,8 kHz entspricht. Dieses Korrekturtropfensteuersignal wird nun zum Steuergerät der Mikrodosiervorrichtung gesendet, das es wiederum an die Piezopipette anlegt, wodurch die Frequenz der Tropfen und damit die Größe der Einheit Kristall mit Flüssigkeitsumgebung abnimmt. Sollte sich nun bei Wiederholung des beschriebenen Verfahrens herausstellen, daß die erneut aufgenommenen und an das Regelement übertragenen Bilddaten eine Abweichung vom Flächensollwert nach unten anzeigen, so würde über ein erneut ermittelte und vom Regelement an die Mikrodosiervorrichtung gesendetes Tropfensteuersignal die Frequenz der Tropfen erneut verändert, bis ein Gleichgewicht zwischen Abdampfen von Flüssigkeit und Zugewinn durch Betropfen eingestellt ist. Das Verfahren wird solange wiederholt, bis der Kristallbehandlungsprozeß erfolgreich abgeschlossen ist. Anstelle oder zusammen mit der Frequenz der Tropfen können auch die Größe und/oder Form über modifizierte Tropfensteuersignale eingestellt werden.

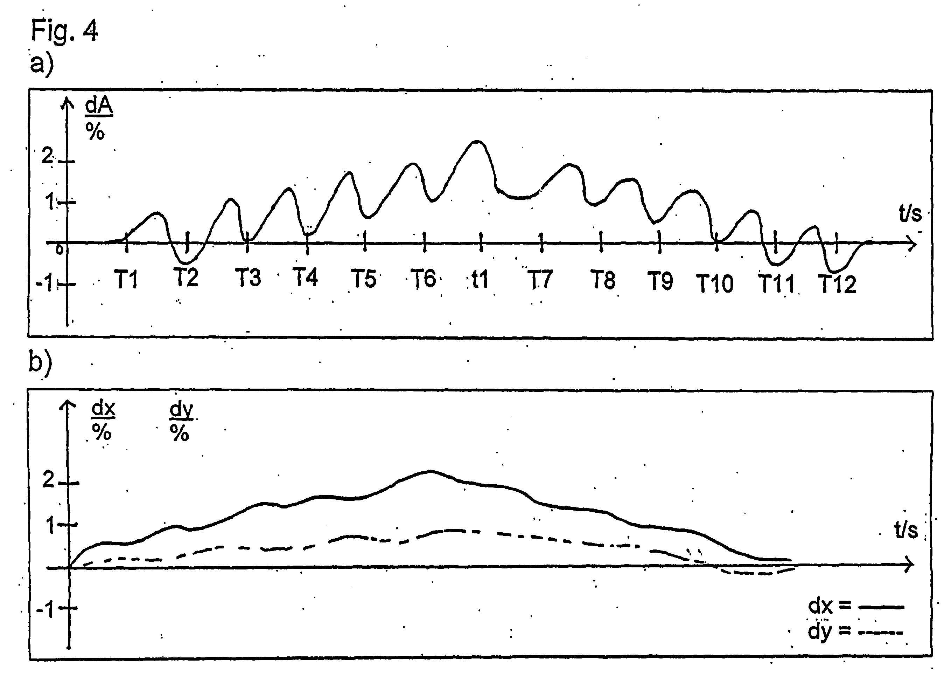

Fig. 4 a zeigt eine graphische Darstellung des durch das erfindungsgemäße Verfahren gemessenen Verlaufs der Änderung der Fläche des Kristalls mit Flüssigkeitsumgebung in dem von dem Bildaufaahmesystem aufgenommenen Bild, wobei die Änderung in Prozent angegeben ist. Gemäß einer bevorzugten Ausführungsform können die in regelmäßigen Zeitabständen bestimmten Flächenwerte abgespeichert und dann zu einem Monitor gesendet werden, auf dem sie dann für einen Bediener angezeigt werden. In der Fig. 4a) wurde zu den Zeitpunkten T1, T2, T3, ...., T12 jeweils ein Mikrotropfen von dem durch das Regelelement angesteuerten Mikrodosiersystem auf den Kristall mit Flüssigkeitsumgebung aufgetropft. Nach jedem Tropfen steigt die über das Videosystem in Verbindung mit dem Regelelement ermittelte Flächenänderung dA kurz an, wobei dA danach durch Wasserverdampfung abfällt, bis ein neuer Tropfen durch das Mikrodosiersystem auf den Kristall mit Flüssigkeitsumgebung aufgebracht wird. Es ist in der Fig. 4a) darüber hinaus zu erkennen, daß bis zum Zeitpunkt t1 die Flächenänderung ständig zunimmt. Um dem entgegenzuwirken, wird zum Zeitpunkt t1 durch das Regelelement ein Signal zum Mikrodosiersystem gesendet, was eine geringere Auftropffrequenz repräsentiert. Dadurch werden weniger Tropfen pro Zeiteinheit aufgetropft, wodurch die Flächenänderung dA nach dem Zeitpunkt t1 allmählich wieder abnimmt. In der Fig. 4b) sind weitere Graphen dargestellte die auf dem Monitor angezeigt werden können. Dabei bezeichnet dx die prozentuale Änderung der Ausdehnung des Bildes "Kristall mit Flüssigkeitsumgebung" in x-Richtung in dem gesamten aufgenommen Bild. Dy bezeichnet entsprechend die prozentuale Änderung des zweidimensionalen Bildes des Kristalls mit Flüssigkeitsumgebung in y-Richtung. Beide Werte können aus dem vom Videosystem empfangenen Bild im Regelelement z.B. durch Pixelanalyse ermittelt werden. Die Werte zeigen an, ob sich die Einheit "Kristall mit Flüssigkeitsumgebung" in der einen oder anderen Richtung stärker ausgedehnt hat.

Gemäß einer weiteren Ausführungsform des erfindungsgemäßen Verfahrens kann auch über die Steuerung der Zusammensetzung der Gasumgebung des Proteinkristalls versucht werden, ein Gleichgewicht zwischen Abdampfen von Flüssigkeit und Flüssigkeitszugewinn der Einheit Kristall mit Flüssigkeitsumgebung zu erzielen. Hierzu kann bei Abweichungen zwischen dem Flächensollwert und dem über das Bildsignal gemessenen momentanen Flächenwert ein Gaszusammensetzungssteuersignal über das Regelement 100 zum Gasumgebungserzeugungsinittel 400 gesendet werden, mit dem z.B. dann, wenn es sich bei dem Gas um Luft mit einem bestimmten Feuchtigkeitsgehalt handelt, dieser verändert werden kann, bis ein Gleichgewicht zwischen Abdampfen von der Einheit "Kristall mit Flüssigkeitsumgebung" und Flüssigkeitszugewinn der Einheit "Kristall mit Flüssigkeitsumgebung" erreicht ist. Wie sich die Einstellung der Luftfeuchtigkeit erreichen läßt, ist im Stand der Technik bekannt und z.B. in der oben bereits erwähnten Deutschen Patentanmeldung Nr. 102321728-52 mit dem Titel "Vorrichtung und Verfahren zur Erzeugung einer definierten Umgebung für partikelförmige Proben" beschrieben, gemäß der sich eine hochgenaue und langzeitstabile Feuchteeinstellung eines durch die oben beschriebene Halterung geführten feuchten Gasstroms am Ort des partikelförmigen Kristalls erreichen läßt. Je höher der Feuchtigkeitsgehalt in der Luft eingestellt wird, umso mehr Wasser aus der Gasumgebung nimmt der Kristall mit Flüssigkeitsumgebung auf, so daß z.B. durch Einstellung eines höheren Feuchtigkeitsgehalts im Gasstrom einer zu starken Verdampfung von Wasser aus der Einheit "Kristall mit Flüssigkeitsumgebung" entgegengewirkt werden kann.

Gemäß einer weiteren alternativen Ausführungsform des erfindungsgemäßen Verfahrens können auch gleichzeitig sowohl die Tropfenzugabe als auch der den Kristall mit Flüssigkeitsumgebung umgebende Gasstrom in seiner Zusammensetzung geregelt werden. Hierzu muß das Regelelement bei Abweichungen zwischen Sollflächenwert und Istflächenwert eine ideale Kombination aus Tropfenzugabe (d.h. Tropfenfrequenz, Tropfengröße, Tropfenform) und Gasumgebungszusammensetzung ermitteln und entsprechende Tropfensteuerkorrektursignale bzw. Gaszusammensetzungssteuersignale an die Mikrodosiervorrichtung bzw. das Gasumgebungserzeugungsmittel senden.

Gemäß einer weiteren Ausführungsform des erfindungsgemäßen Verfahrens kann anstelle der Fläche des Kristalls mit Flüssigkeitsumgebung in einem aufgenommenen Bild auch das Volumen des Kristalls mit Flüssigkeitsumgebung bestimmt werden. Hierzu sind allerdings mehrere Videosysteme erforderlich, mit denen der Kristall mit Flüssigkeitsumgebung aus verschiedenen Lagen aufgenommen werden kann. Die aus verschiedenen Lagen zum gleichen Zeitpunkt aufgenommenen Bilder können dann im Regelelement ausgewertet werden, um aus den Bildern die Volumeninformation zu gewinnen. Zur Auswertung können dabei z.B. photogrammetrische oder andere im Stand der Technik bekannte Verfahren verwendet werden, die eine Bestimmung des Volumens eines Körpers aus zweidimensionalen Aufnahmen des Körpers erlauben, die aus verschiedenen Lagen angefertigt wurden und zum Teil identische Körperpunkte enthalten

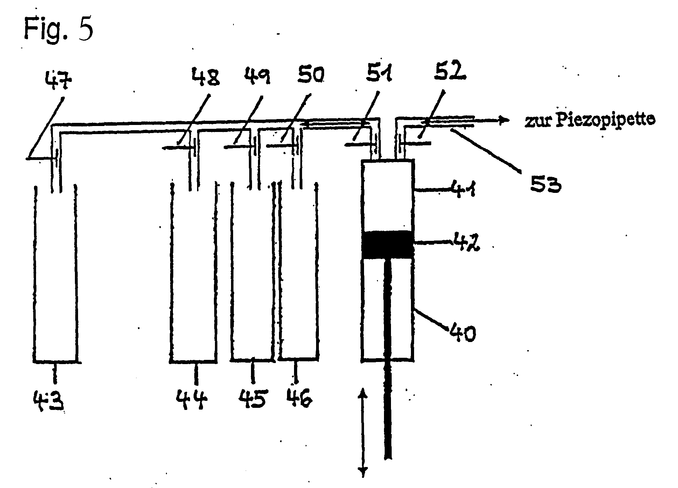

Gemäß einer weiteren Ausführungsform kann die Piezopipette auch mit einem speziellen Flüssigkeitzufuhrsystem versehen sein, mit dem es möglich ist, die Zufuhr verschiedener Flüssigkeiten in die Piezopipette zeitlich in gewünschter Weise zu steuern. In der Fig. 5 ist ein solches Flüssigkeitszufuhrsystem darstellt Das in der Fig. 5 dargestellte Flüssigkeitszufuhrsystem umfaßt eine Präzisionsspritze 40 (elektrisch ansteuerbar), die aus einem Zylinder 41 besteht, in dem ein über einen (in der Fig. 3 nicht dargestellten) Motor angetriebener Kolben 42 hin- und herlaufen kann. Wenn der Kolben nach unten läuft, können verschiedene Flüssigkeiten aus den Flüssigkeitsbehältern 43, 44, 45 oder 46 in den Zylinder gesaugt werden, wenn eines der entsprechenden elektrisch ansteuerbaren Ventile 47, 48, 49 bzw. 50 geöffnet wird und zusätzlich das vor dem Zylinder liegende elektrisch steuerbaren Ventil 51 geöffnet wird. Wird das Ventil 51 dann wieder geschlossen, das am Auslaß des Zylinders liegende elektrisch steuerbare Ventil 52 geöffnet und der Kolben 42 nach oben getrieben, so kann die angesaugte Flüssigkeit über die zur Piezopipette führende Flüssigkeitszufuhrleitung 53 zur Piezopipette geführt werden, um dann schließlich in Tropfenform auf den Kristall gegeben werden zu können.

Die Behälter 45 und 46 können z.B. zwei verschiedene Lösungen mit verschiedenen Liganden enthalten, die mit dem Protein des zu betropfenden Kristall einen Komplex bilden sollen. Die Behandlung des Kristalls kann dabei z.B. so erfolgen, daß zunächst die Lösung 1 aus dem Behälter 45 und danach die Lösung 2 aus dem Behälter 46 auf den Kristall aufgetropft wird. Zwischen den beiden Lösungen kann eine Reinigungslösung durch die Leitungen gespült werden, die sich in dem Behälter 44 befindet. Der weitere Behälter 43 dient als Abfallbehälter, um Flüssigkeitsmengen aufzunehmen, die nicht mehr benötigt werden und aus dem Zufuhrsystem entfernt werden müssen. Durch geeignete zeitliche Ansteuerung der Ventile 47 - 52 und des Kolbens 42 können nun der Piezopipette die gewünschten Lösungen in der gewünschten Menge zugeführt werden.

Die zeitliche Ansteuerung der Ventile kann gemäß einer bevorzugten Ausführungsform des erfindungsgemäßen Verfahrens ebenfalls durch den Mikroprozessor (µP) des in der Fig. 3 mit 100 gekennzeichneten Regelelements erfolgen. Dabei wird zunächst im Speicher des µP eine gewünschte zeitliche Abfolge der Öffnungs- und Schließmomente der elektrisch ansteuerbaren Ventile abgelegt. Während des Kristallbehandlungsprozesses werden dann an den gespeicherten Zeiten elektrische Signale oder Funksignale vom Regelelement zu den elektrisch ansteuerbaren Ventilen gesendet, um die Ventile in geordneter Weise zu öffnen und zu schließen. Die Flüssigkeitsbehälter können darüber hinaus auch mit elektrisch abfragbaren Füllstandsmessgeräten ausgestattet sein, die nach Aussendung eines Abfragesignals durch das Regelelement 100 ein Signal, das den aktuellen Füllstand des Behälters repräsentiert, zum Regelelement 100 zurücksenden. Das Regelelement kann diese Füllstandssignale auswerten und auf einem mit dem Regelelement verbundenen Monitor für den Bediener zur Anzeige bringen, so daß dieser stets über die aktuellen Füllstände informiert ist Vorzugsweise kann das Regelelement auch ein Warnsignal auf dem Monitor oder in akustischer Form ausgeben, wenn während eines Kristallbehandlungsprozesses der Flüssigkeitsstand einen bestimmten vorher im Speicher des µP abgelegten kritischen Restwert (z.B. 5%) unterschreitet, so daß der Bediener rechtzeitig ein Nachfüllen des Flüssigkeitsbehälters veranlassen kann. Anstelle der in der Fig. 5 dargestellten Ventile können auch andere Flußregler verwendet werden, die sich elektrisch ansteuern lassen, z.B. Massendurchflußregler.

Gemäß einer weiteren Ausführungsform der Erfindung können auch mehrere Mikrodosiersysteme, z.B. mehrere Piezopipetten, verwendet werden, mit denen jeweils unterschiedliche oder auch identische Substanzen (bspw. an zwei verschiedenen, lokal abgegrenzten Bereichen des Kristalls) auf den Kristall aufgebracht werden. Eine solche Anordnung kann z.B. von Vorteil sein, wenn zwei verschiedene Liganden in eine Proteinkristallstruktur eingebracht werden sollen. Die Liganden werden dann in verschiedenen Lösungen gelöst, die in die beiden Flüssigkeitsvorratsbehälter zweier Piezopipetten gegeben werden. Über die beiden Piezopipetten werden dann die beiden Lösungen mit den verschiedenen Liganden in Makro-Tropfenform auf den Proteinkristall aufgebracht. Dabei können über das mit einer Piezopipette jeweils verbundene Steuergerät, das die Tropfenerzeugung steuert, unterschiedliche Spannungsimpulse und Spannungspulsfolgen an die Piezopipetten angelegt werden, um so eine optimale Form und Frequenz der Mikro-Tropfen zu erreichen, die für den jeweiligen Liganden ideal ist

Die Verwendung von zwei Mikrodosiersystemen, mit denen getrennt zwei verschiedene Substanzen aufgebracht werden, die erst auf dem Kristall zusammentreffen, ist insbesondere auch dann vorteilhaft, wenn das kristallisierte Protein Katalysatorfunktion für die beiden Substanzen, die beide als Reaktanden im kristallisierten Protein gebunden werden, hat. Erfolgt das Aufspritzen der beiden Reaktanden separat durch zwei Mikrodosiersysteme während der Röntgenbestrahlung des Proteinkristalls, kann die Reaktion der Reaktanden unter katalytischem Einsatz der kristallisierten Proteine verfolgt werden. Eine Voraussetzung für eine derartige röntgenkristallographische Untersuchung ist natürlich die Stabilität des Kristalls, d.h., daß der Kristall seine Struktur nicht durch strukturelle Umlagerungen der kristallisierten Proteine verlieren darf, da er dadurch auch sein Diffraktionsvermögen verlieren würde.

Bei der Verwendung von mehreren Mikrodosiersystemen, die durch das Regelelement angesteuert werden, muß die Regelung entsprechend angepaßt werden. Hier muß das Regelelement nach Messung der aktuellen Ausdehnung des Kristalls mit Flüssigkeitsumgebung über das Videosystem, Korrekturtropfensteuersignale für jedes der Mikrodosiersysteme berechnen und dann zu den jeweiligen Systemen aussenden. Hierbei muß neben einer Vorgabe in Bezug auf die aus den Bildern des Videosystems ermittelte Gesamtfläche bzw. das Gesamtvolumen des Kristalls + Flüssigkeitsumgebung auch die gewünschte Reaktionskinetik berücksichtig werden, d.h. es können bestimmte Randbedingungen in Bezug auf das Verhältnis der aus den verschiedenen Mikrodosiersystemen pro Zeiteinheit auf zu tropfenden Flüssigkeitsmengen vorher festgelegt werden, indem sie im Speicher des µP als eine Art Flüssigkeitsverhältnisverteilungsschema abgelegt werden.

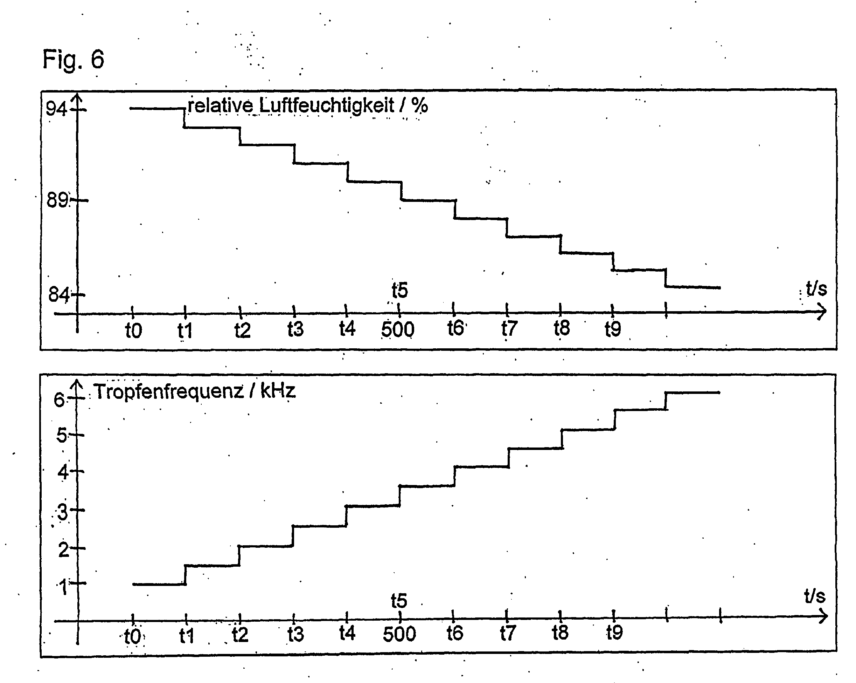

Gemäß einer weiteren Ausführungsform des erfindungsgemäßen Verfahrens kann auch vor Beginn des Kristallbehandlungsprozesses ein bestimmter zeitlicher Verlauf der Zusammensetzung der den Kristall + Flüssigkeitsumgebung umgebenden Gasumgebung und ein bestimmter zeitlicher Verlauf der Frequenz (und/oder Größe und/oder Form) der von dem Mikrodosiersystem auf den Kristall + Flüssigkeitsumgebung aufzubringenden Tropfen definiert werden. In diesem Fall wird ein entsprechender Ablauf in Form einer Nachschlagetabelle, in der die einzelnen Gasumgebungssteuersignalwerte und Frequenzsteuersignalwerte den Steuerzeitpunkten zugeordnet sind, im Speicher des µP abgelegt Während des Kristallbehandlungsprozesses werden dann zu den gespeicherten Steuerzeitpunkten die Frequenzsteuerungssignale zur Mikrodosiervorrichtung und die Gasumgebungssteuersignale zum Gasumgebungserzeugungsmittel abgegeben. In der Fig. 6 ist für eine Ausführungsform, bei der das Gas Luft mit einem bestimmten Feuchtigkeitsgehalt (H₂O) dargestellt ist, wie die relative Luftfeuchtigkeit im Laufe des Kristallbehandlungsprozesses allmählich heruntergefabren wird, und zwar von 94% auf 84%. Dabei werden zu den Zeitpunkten t0, t1, t2, .....t10 jeweils Gasumgebungssteuersignale vom Regelelement zum Gasumgebungserzeugungsmittel gesendet, das hier aus einem Luftfeuchtigkeitseinstellmittel besteht. Während des allmählichen Reduzierens der relativen Luftfeuchtigkeit des den Kristall + Flüssigkeitsumgebung umgebenden Luftstroms wird gleichzeitig die Tropfenfrequenz allmählich von 1 kHz auf 6 kHz erhöht, indem zu den Zeitpunkten t0, t1, t2, ....., t10 entsprechende Frequenzsteuersignale vom Regelelement 100 zum Mikrodosiersystem gesendet werden. Durch Zurückfahren der Luftfeuchtigkeit bei gleichzeitigem Erhöhen der Auftropffrequenz der Wasser enthaltenden Tropfen auf den Kristall + Flüssigkeitsumgebung wird das Volumen des Kristalls + Flüssigkeitsumgebung im wesentlichen konstant gehalten. Das führt zu einer geringen Belastung des Kristalls, was insbesondere bei empfindlichen Proteinkristallen vorteilhaft ist. Zwischen den in der Fig. 6 dargestellten Zeitpunkten t0, t1, t2, ...., t10 erfolgt die Einstellung der Luftfeuchtigkeit/Tropfenfrequenz durch das Regelelement in der oben beschriebenen Weise, in dem über das Messen des Volumens der Einheit Kristall + Flüssigkeitsumgebung (oder deren Fläche im Bild) und Vergleich mit einem Volumen- (oder Flächen-)Sollwert entsprechende Korrektursignale ermittelt und ausgesendet werden (was in der Fig. 6 aus Gründen der Übersichtlichkeit nicht dargestellt ist). Gemäß einer weiteren Ausführungsform des erfindungsgemäßen Verfahrens kann auch ein bestimmter gewünschter Gradient (wie er z.B. in der Fig. 6 dargestellt ist) der Luftfeuchtigkeit vor der Kristallbehandlung im Regelelement einprogrammiert werden, wobei während der Kristallbehandlung mit der aufgetropften Flüssigkeit automatisch diejenige Tropfenfrequenz ermittelt wird, die geeignet ist, um das aktuelle Volumen der Einheit Kristall + Flüssigkeitsumgebung konstant zu halten. Hierzu kann das oben beschriebene Verfahren eingesetzt werden, bei dem die vom Videosystem aufgenommenen Bilder der Einheit Kristall + Flüssigkeitsumgebung vom Regelelement ausgewertet und dann der ermittelte Flächen- oder Volumenwert mit einem Sollwert verglichen wird, dessen Über- oder Unterschreiten ein entsprechendes Kortekturtropfensteuersignal auslöst, mit dem die Frequenz (und/oder Form, Größe) der von dem Mikrodosiersystem abgegebenen Tropfen entsprechend verändert wird, so daß das Volumen des Kristalls + Flüssigkeitsumgebung in etwa konstant bleibt.

Ein wesentlicher Vorteil der soeben beschriebenen Ausführungsformen, bei denen mit einem Luftfeuchtigkeitsgradienten gearbeitet wird, besteht darin, daß dadurch die Durchführungsgeschwindigkeiten für die Kristallbehandlungsprozesse wesentlich erhöht werden können, da mit höheren Auftropffrequenzen gearbeitet werden kann. Dieses ist besonders bei solchen Inhibitoren und anderen Proteinkristallen einzubringenden Substanzen von Vorteil, die nur eine geringe Wasserlöslichkeit aufweisen, da eine sehr große Tropfenanzahl auf den Proteinkristall aufgebracht werden muß, um den Prozeß der Kristallbehandlung erfolgreich abschließen zu können.

Anstelle von Wasser können natürlich für die Betropfungsflüssigkeit auch andere Lösungsmittel verwendet werden, in denen Inhibitoren oder andere in die Kristallstruktur einzubringende Stoffe gelöst sein können. So können z.B. DMSO, Ethanol, Isopropanol oder DMF (Dimethylformamid) verwendet werden. Viele Inhibitoren haben in diesen Lösungsmitteln eine bessere Löslichkeit als in Wasser, wodurch das Kristallbehandlungsverfahren beschleunigt werden kann, da weniger Tropfen auf den Kristall aufgebracht werden müssen. Auch dem Gasstrom, der um den Kristall während der Betropfung herum geführt wird, kann ein Lösungsmittel beigemischt werden, das sich von Wasser unterscheidet. Bei der Verwendung anderer Lösungsmittel ist auch die Tropfengröße zu beachten, die in der Regel über der Tropfengröße von Wasser liegen wird. So hat zum Beispiel DMSO eine Tropfengröße, die um einen Faktor 4-5 über der von Wasser liegt Die Tropfengröße darf aber nicht zu groß sein, da sie - wie oben erwähnt - in einem bestimmten Verhältnis zur Größe des Kristalls stehen muß. Darüber hinaus können auch Gemische verschiedener Lösungsmittel verwendet werden.

Gemäß einer weiteren Ausführungsform des erfindungsgemäßen Verfahrens kann auch ein Stroboskop mit Blitzlampe vorgesehen sein, um die Beobachtung der Tropfen während des Kristallbehandlungsprozesses zu ermöglichen. Dabei kann das Stroboskop mit dem Steuergerät, das die Tropfenbildung auslöst, verbunden sein und gleichzeitig mit dem Signal, das die Abgabe eines Tropfens auslöst, angesteuert werden, so daß Tropfenabgabe und Blitzlicht synchronisiert sind.

Darüber hinaus kann bei einer weiteren Ausführungsform des erfindungsgemäßen Verfahrens eine Vorrichtung zur Drehung des Kristalls vorgesehen sein. Wenn der Kristall während der Tropfenaufbringung gedreht wird, kann der Kristallbehandlungsprozeß schneller abgeschlossen werden, da eine gleichmäßige Verteilung der Flüssigkeit über die Oberfläche der Einheit "Kristall mit Flüssigkeitsumgebung" erfolgt. Werden zudem während der Drehung Aufnahmen mit dem Bildaufnahmesystem gemacht, so kann aus diesen Aufnahmen mithilfe bekannter Bildauswerteverfahren das Volumen des Kristalls mit Flüssigkeitsumgebung errechnet werden.

Da sowohl der Kristall als auch dessen Flüssigkeitsumgebung in der Regel nahezu transparent sind und das Bildaufnahmesystem lediglich die Begrenzungen der (in der Regel vor weißem Hintergrund aufgenommenen) Einheit "Kristall mit Flüssigkeitsumgebung" erkennen kann, kann vor der Bildauswertung zum Zwecke der Flächen- oder Volumenbestimmung eine automatische Pixelauffüllfunktion vorgesehen sein, gemäß der die Pixel im Bild mit schwarzen Pixeln aufgefüllt werden, die innerhalb der durch schwarze Pixel erkennbaren Begrenzungen der Einheit "Kristall mit Flüssigkeitumgebung" liegen. Auch können bestimmte andere weiße Pixel-Bereiche innerhalb des Kristalls oder der Flüssigkeitsumgebung, die sich durch Lichtspiegelungen oder anderen unerwünschte optische Effekte ergeben, automatisch mit schwarzen Pixeln aufgefüllt werden, um eine korrekte Flächen- oder Volumenbestimmung zu ermöglichen. Bei der Flächen- oder Volumenbestimmung wird nach Durchführung der oben beschriebenen Korrektur dann einfach das Verhältnis zwischen schwarzen und weißen Pixeln ausgewertet.

## Patentansprüche

1. Verfahren zur Steuerung der Behandlung eines Kristalls mit einer Flüssigkeit mit den folgenden Schritten:
a) es wird der Kristall in einer Halterung frei von Oberflächenlösung befestigt;
b) es wird von mindestens einem Bildaufnahmesystem ein Bildsignal empfangen, das ein momentanes Bild des in der Halterung befestigten Kristalls mit Flüssigkeitsumgebung repräsentiert, wobei auf den Kristall während des Kristallbehandlungsprozesses Tropfen von einem elektrisch steuerbaren Mikrodosiersystem aufgebracht werden, die eine Flüssigkeit enthalten, mit der der Kristall behandelt werden soll;
c) es wird das Bildsignal verarbeitet und aus dem Bildsignal werden die momentane Fläche des zweidimensionalen Bildbereichs, der die Einheit Kristall mit Flüssigkeitsumgebung repräsentiert, oder das momentane Volumen der Einheit Kristall mit Flüssigkeitsumgebung ermittelt;
d) es wird die momentane Fläche oder das momentane Volumen mit einem Sollwert verglichen;
e) bei Abweichung der Fläche oder des Volumens vom Sollwert wird ein Korrekturtropfensteuersignal ermittelt und zu dem Mikrodosiersystem gesendet, wobei das Korrekturtropfensignal so ausgebildet ist, dass es eine korrigierte Frequenz und/oder Größe und/oder Form der von dem Mikrodosiersystem auf den in der Halterung befestigten Kristall mit Flüssigkeitsumgebung aufzubringenden Tropfen repräsentiert, die so gewählt ist bzw. sind, dass die Abweichung vom Sollwert minimiert wird; und
f) es wird vorzugsweise bei Abweichung der Fläche oder des Volumens vom Sollwert ein Gaszusammensetzungskorrektursignal zu einem elektrisch steuerbaren Gasumgebungserzeugungsmittel gesendet, das dazu dient, um den in der Halterung befestigten Kristall mit Flüssigkeitsumgebung herum eine Gasumgebung definierter Zusammensetzung zu erzeugen, wobei das Gaszusammensetzungskorrektursignal eine veränderte Zusammensetzung der Gasumgebung repräsentiert.

2. Verfahren nach Anspruch 1, bei dem die Schritte wiederholt durchgeführt werden, bis der Kristallbehandlungsprozess abgeschlossen ist.

3. Verfahren nach einem der Ansprüche 1 bis 2, bei dem vor dem Schritt 1 des Verfahrens zu dem Mikrodosiersystem ein Starttropfensteuersignal gesendet wird, das so ausgebildet ist, dass es die Anfangsfrequenz und/oder Anfangsgröße und/oder Anfangsform der von dem Mikrodosiersystem auf den in einer Halterung befestigten Kristall mit Flüssigkeitsumgebung zu Beginn der Kristallbehandlung aufzubringenden Tropfen repräsentiert.

4. Verfahren nach einem der vorhergehenden Ansprüche, bei dem vor dem Beginn der Kristallbehandlung mit der durch das Mikrodosiersystem aufzutropfenden Flüssigkeit mittels des Bildaufnahmesystems ein Startbild des Kristalls mit Flüssigkeit aufgenommen wird und ein Signal empfangen wird, das das Startbild repräsentiert, und vorzugsweise aus dem Startbild die momentane Fläche des zweidimensionalen Bildbereichs, der die Einheit Kristall mit Flüssigkeitsumgebung repräsentiert, oder das momentane Volumen der Einheit Kristall mit Flüssigkeitsumgebung ermittelt wird und der ermittelte Wert später als Sollwert verwendet wird.

5. Verfahren nach einem der vorhergehenden Ansprüche, bei dem das Gasumgebungserzeugungsmittel aus einem Mittel besteht, das so ausgebildet ist, dass es einen Luftstrom mit definierter Luftfeuchtigkeit um den Kristall mit Flüssigkeitsumgebung herum erzeugen kann, und vorzugsweise durch das Gaszusämmensetzungskorrektursignal die Luftfeuchtigkeit des Luftstroms, der den in der Halterung befestigten Kristall mit Flüssigkeitsumgebung umgibt, verändert wird.

6. Verfahren nach einem der vorhergehenden Anspräche, bei dem das Korrekturtropfensteuersignal so ausgebildet ist, dass es die Frequenz und/oder die Tropfengröße und/oder die Tropfenform repräsentiert, mit der die Tropfen auf den in der Halterung befestigten Kristall aufgetropft werden.

7. Verfahren nach einem der vorhergehenden Ansprüche, bei dem vor dem Kristallbehandlungsprozess ein Signal empfangen wird, das einen bestimmten zeitlichen Verlauf der Zusammensetzung der Gasumgebung und einen bestimmten zeitlichen Verlauf der Frequenz und/oder Größe und/oder Form der von dem Mikrodosiersystem auf den in der Halterung befestigten Kristall mit Flüssigkeitsumgebung aufzubringenden Tropfen repräsentiert, und vorzugsweise vor dem Kristallbehandlungsprozess ein Signal empfangen wird, das eine während des Kristallbehandlungsprozesses allmählich zunehmende Tropfenfrequenz und eine allmählich abnehmende Luftfeuchtigkeit des den Kristall umgebenden Luftstroms repräsentiert.

8. Verfahren nach einem der vorhergehenden Ansprüche, bei dem ein bestimmten zeitlicher Verlauf der Gaszusammensetzung vorgegeben wird und der dazu passende zeitliche Verlauf der Frequenz und/oder der Größe und/oder Form der von dem Mikrodosiersystem auf den in der Halterung befestigten Kristall mit Flüssigkeitsumgebung aufzubringenden Tropfen automatisch ermittelt wird.

9. Für einen Computer lesbares Medium, auf dem Befehle gespeichert sind, die so ausgebildet sind, dass sie einen Prozessor dazu bringen können, ein Verfahren nach einem der vorhergehenden Ansprüche auszuführen, wobei das Medium vorzugsweise aus einer CD-ROM oder aus einer DVD besteht.

10. Verfahren nach einem der Ansprüche 1 bis 8, bei der das Mikrodosiersystem so ausgebildet ist, dass es Mikrotropfen der auf den in der Halterung befestigten Kristall aufzubringenden Flüssigkeit erzeugen kann, die ein Volumen aufweisen, das kleiner als das Volumen des Kristalls ist, und vorzugsweise das Mikrodosiersystem so ausgebildet ist, dass es Mikrotropfen erzeugen kann, deren Volumen zwischen 10 und 20 Prozent des Kristallvolumens und vorzugsweise zwischen 5 und 10 Prozent des Kristallvolumens beträgt, und besonders bevorzugt das Mikrodosiersystem so ausgebildet ist, dass es Mikrotropfen erzeugen kann, deren Volumen zwischen 1 nl und 100 pl, vorzugsweise zwischen 100 pl und 20 pl und noch bevorzugter zwischen 20 pl und 4 pl liegt.

11. Verfahren nach einem der Ansprüche 1 bis 8 oder 10, bei der das Mikrodosiersystem darüber hinaus ein Flüssigkeitszufuhrsystem aufweist, mit dem verschiedene Flüssigkeiten, die auf den in der Halterung befestigten Kristall aufgetropft werden sollen, in zeitlich gesteuerter Weise einem Tropfenerzeugungsteil des Mikrodosiersystems zugeführt werden können, und vorzugsweise das Flüssigkeitszufuhrsystem des Mikrodosiersystems eine elektrisch ansteuerbare Präzisionsspritze und ein Leitungssystem umfasst, mit dem die Präzisionsspritze über elektrisch steuerbare Ventile mit verschiedenen Flüssigkeitsvorratsbehältern und mit dem Tropfenerzeugungsteil des Mikrodosiersystems verbunden werden kann, um diesem Flüssigkeit für die Tropfenerzeugung zuzuführen.

12. Verfahren nach einem der Ansprüche 1 bis 8 oder 10 bis 11, bei der das Mikrodosiersystem so ausgebildet ist, dass es eine Piezopipette umfasst, die das Tropfenerzeugungsteil bildet und vorzugsweise die Piezopipette aus einer Kapillare besteht, die von einem piezoelektrischen Element umschlossen ist, und besonders bevorzugt das Mikrodosiersystem darüber hinaus ein mit der Piezopipette elektrisch verbundenes Steuergerät umfasst, das so ausgebildet ist, dass damit unterschiedlich geformte Spannungspulse an die Piezopipette angelegt werden können, deren Formen die Form und Größe der Mikrotropfen und deren Frequenz die Frequenz der Mikrotropfen steuern.

13. Verfahren nach einem der Ansprüche 1 bis 8 oder 10 bis 12, bei der das Mikrodosiersystem eine Kapillare und ein in der Kapillare angeordnetes Mikroventil umfasst, und vorzugsweise das Mikrodosiersystem darüber hinaus ein Steuergerät zum Ein- und Ausschalten des Mikroventils umfasst, um die Mikrotropfen zu erzeugen.

14. Verfahren nach einem der Ansprüche 1 bis 8 oder 10 bis 13, bei dem mehrere Mikrodosiersysteme vorgesehen sind, die im Verhältnis zur Halterung so angeordnet sind, dass damit Mikrotropfen verschiedener Flüssigkeiten auf den in der Halterung befestigten Kristall mit Flüssigkeitsumgebung aufgebracht werden können.

15. Verfahren nach einem der Ansprüche 1 bis 8 oder 10 bis 14, bei dem die Flüssigkeit aus einer Lösung besteht, und vorzugsweise in der Lösung eine Substanz oder mehrere Substanzen gelöst ist bzw. sind, die in die Struktur des in der Halterung befestigten Kristalls eingebracht werden soll, bzw. sollen oder mit dieser reagieren soll bzw. sollen, und besonders bevorzugt die Substanz bzw. die Substanzen aus einem oder mehreren Liganden oder Inhibitoren besteht bzw. bestehen, oder die Substanz bzw. die Substanzen einen oder mehrere Reaktanden enthält bzw. enthalten, der bzw. die mit dem oder im Proteinkristall reagieren soll bzw. sollen, oder vorzugsweise die Lösung aus Wasser besteht, in dem eine Substanz gelöst ist, die mit einem Proteinkristall wechselwirken soll und besonders bevorzugt die Substanz aus einem. Inhibitor oder Liganden besteht, der in Wasser nur schwer löslich ist.

## Claims

1. A method for controlling the treatment of a crystal with a liquid, comprising the following steps:
a) the crystal is fixed onto a holder free of surface solution;
b) an image signal representing a momentary image of the crystal fixed onto the holder with liquid requirement is received from at least one image capturing system, wherein drops are applied onto the crystal during the crystal treatment process by means of an electrically controllable microdosage system, the drops containing a liquid the crystal is to be treated with;
c) the image signal is processed and the momentary surface of the two-dimensional image region representing the entity of crystal with liquid environment or the momentary volume of the entity of crystal with liquid environment are determined from the image signal;
d) the momentary surface or the momentary volume are compared to a reference value;
e) in case of deviation of the surface or the volume from the reference value, a drop adjustment control signal is determined and is sent to the microdosage system, wherein the drop adjustment signal is configured such that it represents a corrected frequency and/or size and/or shape of the drops to be applied onto the crystal fixed onto the holder with liquid environment by means of the microdosage system, the frequency and/or size and/or shape being selected such that the deviation from the reference value is minimized; and
f) in case of deviation of the surface or the volume from the reference value, a gas composition adjustment signal is preferably sent to an electrically controllable gas environment generating device that serves for generating a gas environment of defined composition around the crystal fixed onto the holder with liquid environment, wherein the gas composition adjustment signal represents an altered composition of the gas environment.

2. The method according to claim 1, wherein the steps are repeated until the crystal treatment process is completed.

3. The method according to any one of claims 1 or 2, wherein prior to step 1 of the method an initial drop control signal is sent to the microdosage system, the signal being configured such that it represents the initial frequency and/or initial size and/or initial shape of the drops to be applied onto the crystal fixed onto the holder with liquid environment at the initiation of the crystal treatment by means of the microdosage system.

4. The method according to any one of the preceding claims, wherein prior to the initiation of the crystal treatment with the liquid to be dripped on by means of the microdosage system an initial image of the crystal with liquid (environment) is recorded by means of the image capturing system and a signal representing the initial image is received, and wherein the momentary surface of the two-dimensional image region representing the entity of crystal with liquid environment or the momentary volume of the entity of crystal with liquid environment is preferably determined from the initial image and the determined value is subsequently used as reference value.

5. The method according to any one of the preceding claims, wherein the gas environment generating device includes a means configured such that it can generate an air stream around the crystal with liquid environment, the air stream having defined air humidity, and wherein the air humidity of the air stream surrounding the crystal fixed onto the holder with liquid environment is preferably altered by means of the gas composition adjustment signal.

6. The method according to any one of the preceding claims, wherein the drop adjustment control signal is configured such that it represents the frequency and/or the drop size and/or the drop shape with which the drops are dripped onto the crystal fixed onto the holder.

7. The method according to any one of the preceding claims, wherein prior to the crystal treatment process a signal is received which represents a specific time-dependent course of the composition of the gas environment and a specific time-dependent course of the frequency and/or size and/or shape of the drops to be applied onto the crystal fixed onto the holder with liquid requirement by means of the microdosage system, and wherein prior to the crystal treatment process, a signal is preferably received which represents a drop frequency gradually increasing during the crystal treatment process and a gradually decreasing air humidity of the air stream surrounding the crystal.

8. The method according to any one of the preceding claims, wherein a specific time-dependent course of the gas composition is provided and the matching time-dependent course of the frequency and/or size and/or shape of the drops to be applied onto the crystal fixed onto the holder with liquid requirement by means of the microdosage system is automatically determined.

9. A computer-readable medium, on which commands are stored which are configured such that they can cause a processor to carry out a method according to any one of the preceding claims, wherein the medium preferably is a CD-ROM or a DVD.

10. The method according to any one of claims 1 to 8, wherein the microdosage system is configured such that it can generate microdrops of the liquid to be applied onto the crystal fixed onto the holder, the microdrops having a volume that is smaller than the volume of the crystal, and wherein the microdosage system is preferably configured such that it can generate microdrops having a volume of between 10 and 20 percent of the crystal volume and preferably between 5 and 10 percent of the crystal volume, and wherein the microdosage system particularly is preferably configured such that it can generate microdrops having a volume of between 1 nl and 100 pl, preferably between 100 pl and 20 pl, and more preferably between 20 pl and 4 pl.

11. The method according to any one of claims 1 to 8 or 10, wherein the microdosage system further comprises a liquid supply system by means of which different liquids supposed to be dripped onto the crystal fixed onto the holder can be supplied to a drop-generating part of the microdosage system in a time-dependently controlled manner and wherein the liquid supply system of the microdosage system preferably comprises an electrically controllable precision syringe and a duct system by means of which the precision syringe can be connected to different liquid supply containers and to the drop-generating part of the microdosage system via electrically controllable valves in order to feed the microdosage system with liquid for drop generation.

12. The method according to any one of claims 1 to 8 or 10 to 11, wherein the microdosage system is configured such that it comprises a piezo pipette forming the drop-generating part and wherein the piezo pipette preferably comprises a capillary being enclosed by a piezo electric element, and wherein the microdosage system particularly preferably further comprises a control device being electrically connected to the piezo pipette, the control device being configured such that variably shaped voltage pulses can be applied to the piezo pipette by means of the control device, wherein the shapes of the voltage pulses control the shape and size of the microdrops and the frequency of the voltage pulses control the frequency of the microdrops.

13. The method according to any one of claims 1 to 8 or 10 to 12, wherein the microdosage system comprises a capillary and a microvalve arranged inside the capillary, and wherein the microdosage system preferably further comprises a control device for switching on and off the microvalve in order to generate the microdrops.

14. The method according to any one of claims 1 to 8 or 10 to 13, wherein several microdosage systems are provided which are arranged in relation to the holder such that microdrops of different liquids can be applied onto the crystal fixed onto the holder with liquid environment.

15. The method according to any one of claims 1 to 8 or 10 to 14, wherein the liquid is a solution and wherein one or more substances which is/are to be introduced into the structure of the crystal fixed onto the holder or is/are to react with the latter preferably is/are dissolved in the solution, and wherein the substance or the substances particularly preferably include(s) one or more ligand(s) or inhibitor(s), or wherein the substance or the substances include(s) one or more reactant(s) which is/are to react with or in the protein crystal, or wherein the solution preferably comprises water wherein a substance is dissolved which is to interact with a protein crystal, and wherein the substance particularly preferably comprises an inhibitor or a ligand which does not dissolve easily in water.

## Revendications

1. Procédé pour commander le traitement d'un cristal avec un liquide comprenant les étapes suivantes :
a) on monte dans un support le cristal dépourvu de solution de surface ;
b) on reçoit d'au moins d'un appareil d'enregistrement d'image un signal d'image représentant une image actuelle du cristal avec environnement de liquide, qui est monté dans le support, des gouttes qui contiennent un liquide avec lequel le cristal est à traiter étant appliquées sur le cristal pendant le procédé du traitement par un système de microdosage électriquement commandable ;
c) on procède à travailler le signal d'image et à découvrir du signal d'image la surface instantanée du domaine à deux dimensions représentant l'ensemble cristal/environnement liquide ou le volume instantané de l'ensemble cristal/environnement liquide ;
d) on fait la comparaison entre la surface instantanée ou le volume instantané avec une valeur de consigne ;
e) en cas de déviation de la surface ou du volume de la valeur de consigne on procède à calculer un signal de commande pour la goutte de correction et à le transmettre au système de micro-dosage, le signal pour la goutte de correction étant formé à une manière telle qu'il représente une fréquence et/ou une dimension et/ou une forme corrigée des goutte à appliquer par le système de micro-dosage sur le cristal avec environnement de liquide, monté dans le support ; et
f) en cas de déviation de la surface ou du volume de la valeur de consigne on fait transmettre un signal de correction pour la composition du gas à un moyen électriquement commandable pour la création d'un environnement gazeux qui sert à créer un environnement gazeux à composition définie autour du cristal, le signal de correction pour la composition de gaz représentant une composition modifiée d'environnement gazeux.

2. Procédé selon la revendication 1 dans lequel les étapes sont mises en oeuvre répétitivement jusqu'à ce que le procédé de traitement de cristal soit terminé.

3. Procédé selon l'une des revendications 1 à 2, dans lequel précédemment de l'étape 1 du procédé un signal de commande pour la goutte initiale est transmis au système de micro-dosage qui est formé de telle manière qu'il représente la fréquence initiale et/ou la dimension initiale et/ou la forme initiale des gouttes qui sont à appliquer par le système de micro-dosage sur le cristal avec environnement liquide monté dans le support au début du traitement de cristal.

4. Procédé selon l'une quelconque des revendications précédentes, dans lequel précédemment du commencement du traitement de cristal avec du liquide à appliquer par le système de micro-dosage une image initiale du cristal avec de la liquide est prise par l'appareil d'enregistrement d'image et un signal représentant l'image initiale est reçue, et préférentiellement à partir de l'image initiale la surface instantanée de la domaine à deux dimensions représentant l'ensemble cristal/environnement liquide ou le volume instantanée de l'ensemble cristal/environnement liquide est trouvée, et la valeur trouvée est mis en oeuvre comme valeur de consigne ultérieurement.

5. Procédé selon l'une quelconque des revendications précédentes, dans lequel le moyen de création d'environnement gazeux consiste à un moyen qui est formé de telle manière, qu'il peut créer un courant d'air avec une humidité atmosphérique définie autours du cristal avec environnement liquide, et préférentiellement la humidité atmosphérique du courant d'air entourant le cristal avec environnement liquide qui est monté dans le support est modifiée par le signal de correction de la composition de gaz.

6. Procédé selon l'une quelconque des revendications précédentes, dans lequel le signal de commande pour la goutte de correction est formé de telle manière, qu'il représente la fréquence et/ou la dimension de goutte et/ou la forme de goutte, avec laquelle les gouttes sont gouttées sur le cristal qui est monté dans le support.

7. Procédé selon l'une quelconque des revendications précédentes, dans lequel précédemment du procédé de traitement de cristal un signal est reçu, qui représente un cours temporel défini de la composition d'environnement de gaz et un cours temporel défini de la fréquence et/ou de la dimension et/ou de la forme des gouttes à appliquer sur le cristal avec environnement liquide monté dans le support, et préférentiellement précédemment du procédé de traitement de cristal un signal est reçu qui représente une fréquence de goutte accroissante peu à peu pendant le procédé de traitement de cristal et une humidité atmosphérique decroissante peu à peu du courant d'air entourant le cristal.

8. Procédé selon l'une quelconque des revendications précédentes, dans lequel un cours temporel défini de la composition de gaz est prédéterminé et le cours temporel y approprié de la fréquence et/ou de la dimension et/ou de la forme des gouttes à appliquer par le système de microdosage sur le cristal avec environnement liquide monté dans le support est calculé automatiquement.

9. Pour un médium lisable par ordinateur, sur laquelle medium sont stockées des instructions, qui sont réalisées de telle manière, qu'elles font un processeur exécuter un procédé selon l'une quelconque des revendications précédentes, le médium consistant préférentiellement à un CD-ROM ou à un DCD.

10. Procédé selon l'une des revendications 1 à 8, dans lequel un système de micro-dosage est formé de telle manière, qu'il peut créer des micro-gouttes du liquide qui est à appliquer sur le cristal qui est monté dans le support, qui exhibitent un volume inférieur à celui du cristal, et le système de micro-dosage est formé de telle manière, qu'il peut créer des micro-gouttes dont le volume sera compris entre 10 et 20 pourcent du volume du cristal, et le système de micro-dosage est formé préférentiellement de telle manière, qu'il peut créer des micro-gouttes dont le volume sera compris entre 1 nl et 100 pl, préférentiellement entre 100 pl et 20 pl et encore plus préférentiellement entre 20 pl et 4 pl.

11. Procédé selon l'une des revendications 1 à 8 ou 10, dans lequel le système de micro-dosage exhibite en outre un système d'approvisionnement de liquide avec lequel on peut approvisionner de divers liquides qui sont à goutter sur le cristal monté dans le support d'une manière temporellement commandée à une partie de création de gouttes du système de micro-dosage, et le système d'approvisionnement de liquide préférentiellement comprenant une seringue de précision électriquement commandable et un système de conduite, par lequel on peut connecter la seringue de précision et de divers réservoirs de liquide et la partie de création de gouttes du système de micro-dosage au moyen de valves électriquement commandables pour approvisionner cette liquide pour la création de gouttes.

12. Procédé selon l'une des revendications 1 à 8 ou 10 à 11, dans lequel le système de micro-dosage est formé de telle manière qu'il comprend une pipette piézo-électrique formant la partie de création de gouttes et la pipette piézo-électrique préférentiellement consiste à un capillaire qui est entouré par un unité piézo-électrique, et encore plus préférentiellement le système de micro-dosage comprend en outre un appareil de commande qui est connecté à la pipette piézo-électrique, lequel appareil étant formé de telle manière que avec ceci on peut mettre des pulses de voltage de formes différentes dont les formes sont capables de régler la forme et la dimension des micro-gouttes et dont la fréquence règle la fréquence des micro-gouttes.

13. Procédé selon l'une des revendications 1 à 8 ou 10 à 12, dans lequel le système de micro-dosage comprend un capillaire et une micro-valve située dans le capillaire, et le système de micro-dosage préférentiellement comprend un appareil de command pour ouvrir et fermer la micro-valve pour créer les micro-gouttes.

14. Procédé selon l'une des revendications 1 à 8 ou 10 à 13, dans lequel plusieurs systèmes de micro-dosage sont prévus, qui, par rapport au support, sont disposés de telle manière que avec ceux-ci on en peut appliquer des micro-gouttes de divers liquides sur le cristal avec environnement de liquide monté dans le support.

15. Procédé selon l'une des revendications 1 à 8 ou 10 à 14, dans lequel le liquide consiste en une solution et préférentiellement une ou plusieurs matières à incorporer dans ou à faire réagir avec la structure du cristal monté dans le support respectivement sont dissous dans la solution, et encore plus préférentiellement la ou les matières consistant à un ou plusieurs ligands ou inhibiteurs ou la ou les matières consistant à ou contenant un ou plusieurs réactants qui sont à faire réagir avec ou dans le cristal protéine, ou la solution consiste préférentiellement en eau, dans laquelle est dissoute une matière qui est à interagir avec le cristal protéine, et encore plus préférentiellement la matière consistant en un ligand ou inhibiteur qui est difficilement soluble dans l'eau.
